# EUROPEAN PATENT SPECIFICATION

(11) **EP 1 396 127 B1**
(45) Date of publication and mention of the grant of the patent: **08.09.2010**
(21) Application number: 02733061.2
(22) Date of filing: 28.05.2002
(51) Int. Cl.: H04L 25/03

(54) **DECISION FEEDBACK EQUALISER**
ENTSCHEIDUNGSRÜCKGEKOPPELTER ENTZERRER
EGALISEUR A DECISION RETROACTIVE

(30) Priority: 29.05.2001 US 866822
(43) Date of publication of application: 10.03.2004
(73) Proprietor: NXP B.V., 5656 AG Eindhoven (NL)
(72) Inventor: BIRRU, Dagnachew, NL-5656 AA Eindhoven (NL)
(74) Representative: Epping - Hermann - Fischer
(86) International application number: PCT/IB2002/001910
(87) International publication number: WO 2002/098089

(56) References cited:
- US-A- 5 748 674

## Description

The present invention relates generally to a decision feedback equalizer (DFE). More specifically, the present invention relates to circuitry for mitigating the performance loss caused by the feedback loop delay in a DFE. A corresponding method is also disclosed.

A digital transmission is susceptible to multipath fading or the like and invites waveform distortion of the transmitted signal resulting in degradation of signal quality. In order to minimize this problem, it is the current practice to employ an automatic adaptive equalizer using a transversal filter. An adaptive equalizer may be classified into linear and non-linear types. Linear equalization has found extensive use in terrestrial digital microwave communications systems. However, it is unable to effectively minimize deep or severe multipath distortion. Therefore, residual intersymbol interference undesirably increases. In particular, as a signal transmission rate becomes higher and signal propagation distance increases, the linear equalization is no longer sufficient to handle severe frequency selective fading wherein multipath delay spreads over a transmission symbol period. To overcome this problem, a non-linear type equalizer, which takes the form of a decision feedback equalizer (DFE), is often employed. In other words, DFEs are commonly utilized in digital communication systems to reduce the multi-path impairments caused by the channel.

The ATSC standard set forth by the Advanced Television Systems Committee in the document entitled "ATSC Digital Television Standard" (Document A53, September 16, 1995), for terrestrial Digital TV in the United States requires transmission of an MPEG bit stream of 19.28 Mbps over a bandwidth of 6 MHz at a symbol rate of 10.76 MHz in the VHF and UHF carrier frequency range. The modulation scheme used is a single carrier 8 level Vestigial Sideband (VSB) modulation scheme. Systems such as the North American Terrestrial Digital TV rely on DFEs to reduce the multipath impairments.

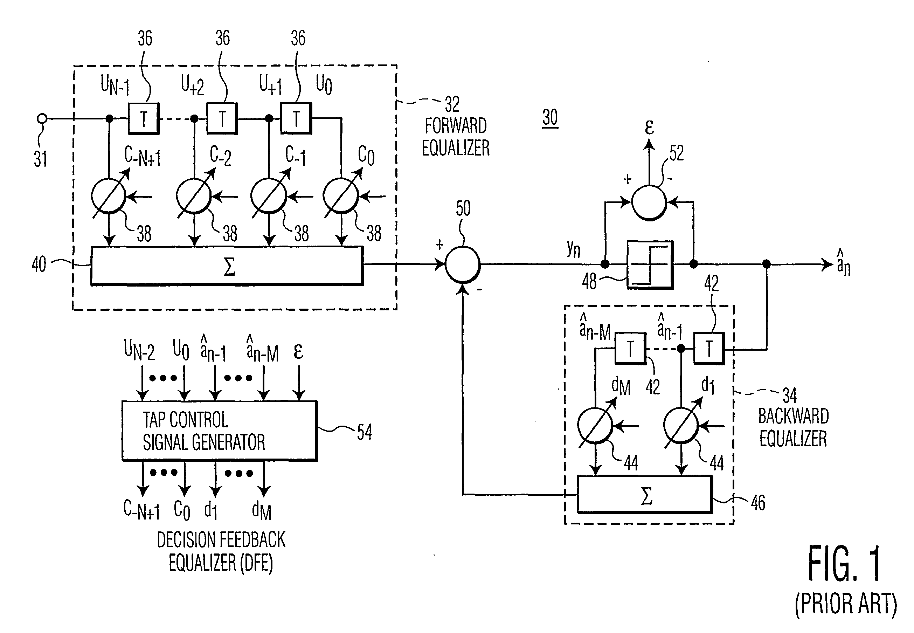

U.S. Patent No. 5,119,401 to Tsujimoto discloses a decision feedback equalizer including forward part whose signal reference point is shiftable depending on channel response. In the '401 patent, Fig. 1 depicts a non-linear type equalizer in the form of a decision feedback equalizer (DFE) denoted by reference numeral 30. The DFE includes a forward equalizer (FE) 32 and a backward equalizer (BE) 34. A center tap c_{O} of the overall DFE 30 is positioned at the final tap of the forward equalizer as shown. The forward equalizer 30 includes N-1 delay circuits 36 coupled in series, N multipliers 38, and an adder 40. On the other hand, the backward equalizer 34 is provided with M delay circuits 42, M multipliers 44 and an adder 46. Further, the DFE 30 includes a decision circuit 48, two subtractors 50, 52, and a tap control signal generator 54.

The DFE 30 operates to minimize intersymbol interference (ISI) in any received signal due to a precursor of an impulse response at the forward equalizer 32, while minimizing ISI caused by a postcursor at the backward equalizer 34. The output of the forward equalizer 32 is subtracted from the output of the backward equalizer 34 at the subtractor 50. The decision signal âₙ (output by the decision circuit 48 and then fed back to the backward equalizer 34) is free of intersymbol interference and noises. Therefore, the equalization capability of the backward equalizer 34 using the decision feedback technique is higher than that of the forward equalizer 32. This means that the backward equalizer 34 is capable of completely removing ISI caused by a postcursor of impulse response (viz., minimum phase shift fading). It is understood that the DFE 30 is superior to the case where only the forward equalizer 32 is provided.

On the other hand, intersymbol interference due to a precursor (non-minimum phase shift fading) is equalized at the forward equalizer 32. Consequently, in connection with the ISI due to non-minimum phase shift fading, the DFE 30 merely implements equalization which is identical to that of the forward equalizer 32. This is the reason why an easily installed linear equalizer 32 is chiefly employed rather than a complex DFE in terrestrial digital microwave communications systems, permitting severe distortion due to non-minimum phase fading to occur frequently.

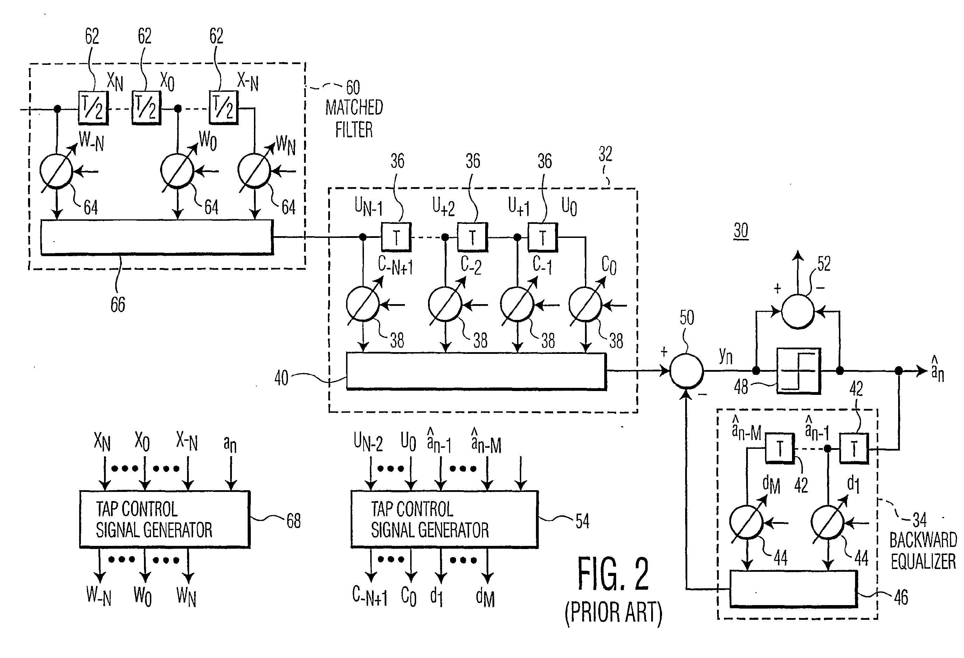

A known approach to effectively removing intersymbol interference caused by non-minimum phase shift fading, is to provide a matched filter (MF) which is followed by a decision feedback equalizer (DEF). Fig. 2 is a block diagram showing one example of this MF/DEF arrangement. The decision feedback equalizer (DFE) 30, which is identical to the arrangement illustrated in Fig. 1, is preceded by a matched filter 60 which includes a plurality of delay circuits 62, each having a symbol interval T/2, a plurality of multiplexers 64, and a tap control signal generator 68. As is well known, a matched filter maximizes the output ratio of peak signal power to mean noise power. The MF/DFE arrangement exhibits excellent precursor distortion equalization performance as compared with the case where the DFE only is provided. However, the MF/DFE is inferior to the DFE in connection with the equalization of the postcursor distortion. This problem, inherent in the MF/DFE, is caused by new waveform distortion introduced by the provision of the MF 60.

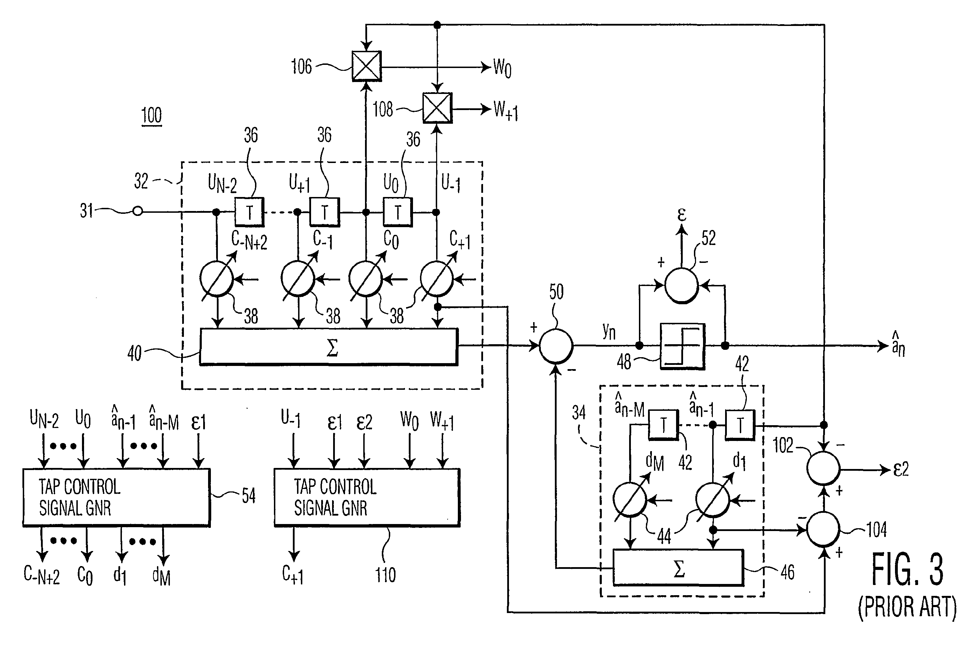

U. S Patent No. 5,119,401 proposes to improve the performance of the decision feedback equalizer by providing a DFE having a forward equalizer whose center tap is shifted by at least one symbol interval towards the final stage of the equalizer. As shown in Fig. 3, the DFE 100 differs from that shown in Fig.1 in that the DFE of Fig. 1 has been modified to include two subtractors 102, 104, two correlators 106,108, and a tap control signal generator 110; moreover, the center tap co of the former arrangement is one-tap shifted towards the input thereof and hence the last tap is denoted by c+1.

It will be appreciated that conventional DFEs, such as thus discussed above, require very long taps in both its forward (FE) and feedback (FBE) equalizers, e. g., impulse filters, to combat the multipath impairment attributable to the channel. Due to design constraints, such long filters are often realized using pipeline structures. Such pipeline structures often introduce unwanted delay, i.e., implementation delay. Moreover, it will be noted that the delay in the feedback path of the equalizer results in a performance penalty. The performance of the equalizer will be degraded for those postcursor echoes that are very close to the main path. For such echoes, little help is provided by the feedback filter, stressing the forward equalizer to do most of the equalization.

Since postcursor echoes close to the main path are common in terrestrial channels, it would be extremely desirable if the feedback path could be realized without unwanted delay. Thus, what is needed is a method and corresponding circuitry for mitigating the performance loss associated with feedback loop delay in a DFE. It would be beneficial if the thus improved method and corresponding DFE circuitry could be implemented at little or no additional cost.

US 5,748,674 discloses a decision feedback equalizer comprising a feedforward filter, a subtractor, a slicer, a first feedback filter with a delay, a second feedback filter, and an adder, in which the outputs of the first and second feedback filters are both connected to the adder, and in which the output of the slicer is connected to the inputs of the feedback filters and to the output of the decision feedback equalizer.

Based on the above and foregoing, it can be appreciated that there presently exists a need in the art for a method and corresponding circuitry which mitigates performance loss caused by feedback loop delay in a decision feedback equalizer which overcomes the above-described deficiencies. The present invention was motivated by a desire to overcome the drawbacks and shortcomings of the presently available technology, and thereby fulfill this need in the art.

According to one aspect, the present invention provides a decision feedback equalizer, as claimed in claim 1.

According to another aspect, the present invention provides a method of decision feedback equalizing as claimed in claim 4.

These and various other features and aspects of the present invention will be readily understood with reference to the following detailed description taken in conjunction with the accompanying drawings, in which like or similar numbers are used throughout, and in which:
Fig. 1 is a block diagram illustrating a conventional decision feedback equalizing arrangement including a forward equalizer and a backward equalizer;
Fig. 2 is a block diagram illustrating a conventional equalizing arrangement which includes a matched filter in the upstream signal flow path of the decision feedback equalizing arrangement shown in Fig. 1;
Fig. 3 is a block diagram illustrating another conventional decision feedback equalizing arrangement having a shifted center tap ;
Fig. 4 is a high-level block diagram of a preferred embodiment of a decision feedback equalizer implemented in a digital television (DTV) receiver according to the present invention;
Fig. 5 is a high-level block diagram of an example of a decision feedback equalizer implemented in a digital television (DTV) receiver; and
Fig. 6 depicts a family of curves illustrating the performance improvement of the DFE according to Fig. 4 with a conventional DFE.

In the discussion which follows, the decision feedback equalizer (DFE) under discussion advantageously can be implemented in a digital television (DTV) receiver or the like. However, it will be appreciated that the improved DFE can be employed in a myriad of digital receivers.

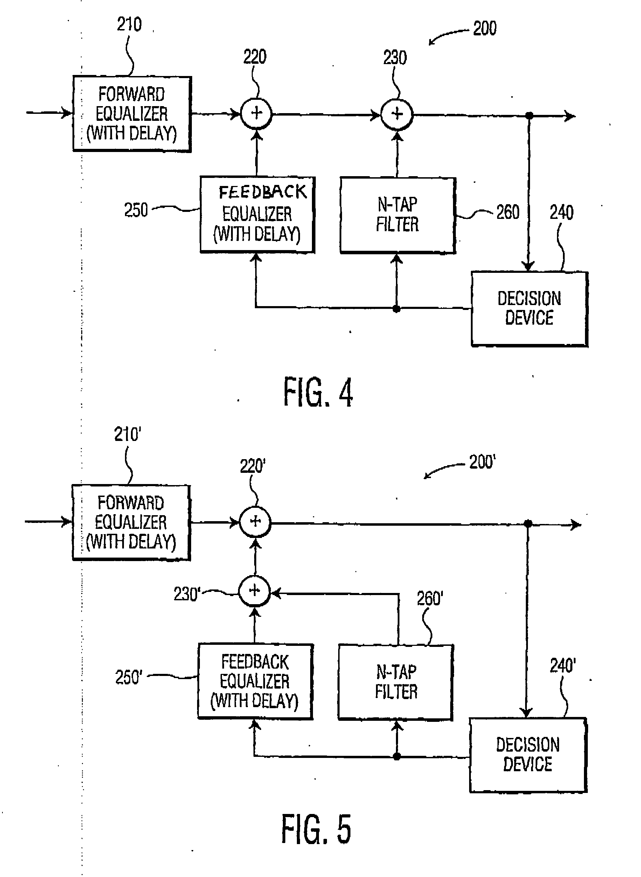

Fig. 4 illustrates a preferred embodiment of a decision feedback equalizer 200 according to the present invention, which includes a forward equalizer 210 connected to a first input port of a first adder 220, a second adder 230 coupled to the output port of the first adder 220. The output port of the second adder 230 is connected to a decision device 240, the output of which is connected to both the input port of a feedback equalizer 250 and the input port of an N tap filter 260. Preferably, the output of the feedback equalizer 250 is provided to a second input port of the first adder 220 while the output of the N-tap filter 260 is provided to a second input port of the second adder 230.

Fig. 5 illustrates an example of a decision feedback equalizer 200', which includes a forward equalizer 210' connected to a first input port of a first adder 220', a second adder 230 coupled to the second input port of the first adder 220'. The output port of the first adder 220'is connected to a decision device 240', the output of which is connected to both the input port of a feedback equalizer 250' and the input port of an N tap filter 260'. Preferably, the outputs of both the feedback equalizer 250' the N-tap filter 260' are provided to the respective input ports of the second adder 230'.

By comparing the DFE 200 illustrated in Fig. 4 with the DFE 30 illustrated in Fig. 1, it will be appreciated that the preferred embodiment according to the present invention includes a small delay compensation filter, i.e., an N-tap filter, in parallel with the feedback equalizer 250. It will be also appreciated that the feedback equalizer 250 can be implemented as a finite impulse response (FIR) filter similar to those depicted in Figs. 1-3.

It should be noted that the length of the N-tap filter 260 equals the number of the unwanted symbol delay, i.e., the implementation delay, introduced by the feedback equalizer loop. For example, when all the implementation delay associated with the feedback equalizer loop are completed within three (N + 1) symbols, then the length of the N-tap filter will be two taps.

The operation of the improved decision feedback equalizer according to the present invention can perhaps best be understood by conceptualizing the feedback equalizer as being a single FIR filter with 100 taps to which coefficients C1 to C100, respectively, are applied that is implemented in two stages. In other words, with respect to Fig. 4, the feedback equalizer includes a first stage feedback equalizer (equalizer 250) implementing coefficients C3 to C 100 and a second stage feedback equalizer (N-tap filer 260) implementing coefficients C1 to C2. Preferably, the N-tap filter 260 is implemented in fast logic so as to minimize implementation delays. Thus, decision feedback equalizer 200 includes a first loop defined by feedback equalizer 250 and a second loop defined by the N-tap filler 260. Advantageously, the coefficients implemented in the N-tap filter 260 can be selected to optimize the processing of postcursor echoes that are very close to the main path.

The loop closed by the N-tap filter 260 can be completed within one symbol period, i.e., within the minimum delay needed (including tap adaptation). Algorithmically, the overall unwanted delay in the feedback path is removed while the design constraints on the feedback equalizer 250 is still relaxed to permit modest pipeline stages.

It should be mentioned that the decision feedback equalizer 200' illustrated in Fig. 5 introduces an additional implementation delay due to the second adder 230' disposed between the output of the feedback equalizer 250' and the first adder 220'. This implementation delay cannot be mitigated by modification of the N-tap filter 260', e.g., implementing an N+1 - or N-1-tap filter in place of the N-tap filter depicted in Fig. 5. However, when the decision feedback equalizer is implemented, for example, as a combination of software controlling a digital signal processor, the implementation delay may be considered insignificant.

To illustrate the advantages of the decision feedback equalizer 200, illustrated in Fig. 4, computer simulations were performed utilizing a channel with impulse response

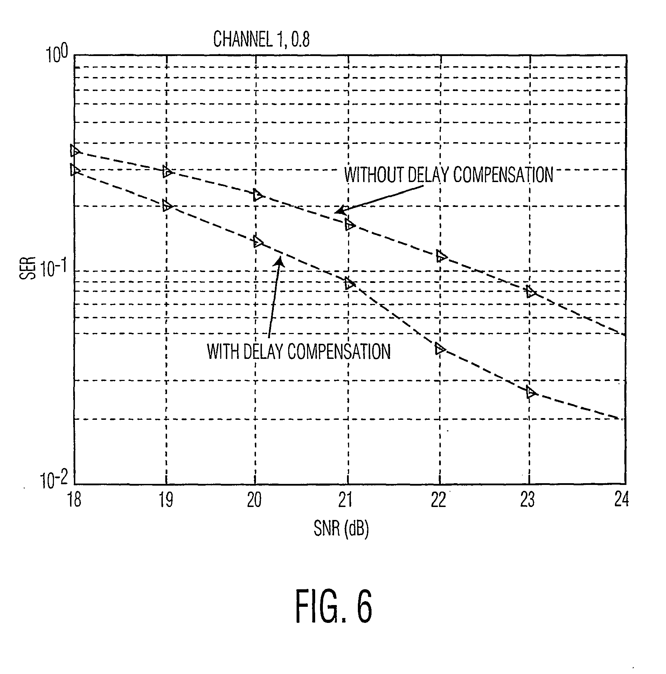

(1.0, 0.8). Fig. 6 plots the simulation result in terms of signal-to-noise ratio (SNR) versus symbol error rate (SER) for the circuits illustrated in Figs 1 and 4. As shown in Fig. 6, the method according to the present invention provides more than 1.5 dB performance improvement compared to the practical equalizer with a delay in its feedback path.

It should be mentioned that there are other advantages to the decision feedback equalizer (DFE) illustrated in Fig. 4 than the static performance advantage. For example, the decision feedback equalizer 200 exhibits faster convergence and better tracking of dynamic channels that contains significant postcursor echoes next to the main path.

For a given technology, a straight forward technique for removing the unwanted latency is to design the feedback part using special adder and multiplier structures in place of the N-tap filter discussed above. This substitution of elements would be particularly advantageous for filters with a relatively small number of taps, but could prove to be inadequate for filters with a relatively large number of taps. At the same time, it will also be noted that the inclusion of additional elements such as the above-mentioned adders and multipliers would increase the design time for the DFE.

It should be mentioned that while the discussion of the preferred embodiments addressed applications involving DTV receivers, the invention is not limited to such applications. Thus, although presently preferred embodiments of the present invention have been described in detail herein, it should be clearly understood that many variations and/or modifications of the basic inventive concepts herein taught, which may appear to those skilled in the pertinent art, will still fall within the scope of the present invention, as defined in the appended claims.

## Claims

1. A decision feedback equalizer (200) comprising:
a forward equalizer (210);
a first adder (220);
a second adder (230);
a decision device (240);
a feedback equalizer (250); and
an N-tap filter (260);
wherein the forward equalizer (210) is connected to a first input of the first adder (220);
the second adder (230) is coupled to an output port of the first adder (220);
an output port of the second adder (230) is connected to the decision device (240) and to the output of the decision feedback equalizer (200);
an output of the decision device (240) is connected to an input port of the feedback equalizer (250) and to an input port of the N-tap filter (260);
an output of the feedback equalizer (250) is coupled to a second input port of the first adder (220); and
an output of the N-tap filter (260) is coupled to a second input of the second adder (230).

2. A decision feedback equalizer (200) as recited in claim 1, wherein the N-tap filter (260) is implemented in fast logic.

3. A decision feedback equalizer as recited in claim 1 or 2, wherein the decision feedback equalizer (200) is suitable for use in a digital television receiver.

4. A method of decision feedback equalizing, comprising:
feeding an output of a forward equalizer (210) to a first input of a first adder (220);
feeding an output of the first adder (220) to a second adder (230);
feeding an output of the second adder (230) to a decision device (240) and to an output outputting the decision feedback equalizing output of the method;
feeding an output of the decision device (240) to an input port of a feedback equalizer (250) and to an input port of an N-tap filter (260);
feeding an output of the feedback equalizer (250) to a second input port of the first adder (220); and
feeding an output of the N-tap filter (260) to a second input of the second adder (230).

5. A method of decision feedback equalizing as recited in claim 4, wherein the N-tap filter is implemented in fast logic.

6. A method of decision feedback equalizing as recited in claim 4 or 5, wherein the method is performed in a digital television receiver.

## Patentansprüche

1. Entscheidungsrückkopplungsentzerrer (200), umfassend:
einen Vorwärtsentzerrer (210);
einen ersten Addierer (220);
einen zweiten Addierer (230);
eine Entscheidungseinheit (240);
einen Rückkopplungsentzerrer (250); und
ein N-Abgriffsfilter (260);
wobei der Vorwärtsentzerrer (210) mit einem ersten Eingang des ersten Addierers (220) verbunden ist;
der zweite Addierer (230) an einen Ausgangsanschluss des ersten Addierers (220) angeschlossen ist;
ein Ausgangsanschluss des zweiten Addierers (230) mit der Entscheidungseinheit (240) und dem Ausgang des Entscheidungsrückkopplungsentzerrers (200) verbunden ist;
ein Ausgang der Entscheidungseinheit (240) mit einem Eingangsanschluss des Rückkopplungsentzerrers (250) und einem Eingangsanschluss des N-Abgriffsfilters (260) verbunden ist;
ein Ausgang des Rückkopplungsentzerrers (250) an einen zweiten Eingangsanschluss des ersten Addierers (220) angeschlossen ist; und
ein Ausgang des N-Abgriffsfilters (260) an einen zweiten Eingang des zweiten Addierers (230) angeschlossen ist.

2. Entscheidungsrückkopplungsentzerrer (200) nach Anspruch 1, wobei das N-Abgriffsfilter (260) als schnell arbeitende Logikschaltung realisiert ist.

3. Entscheidungsrückkopplungsentzerrer nach Anspruch 1 oder 2, wobei der Entscheidungsrückkopplungsentzerrer (200) zum Einsatz in einem digitalen Fernsehempfänger geeignet ist.

4. Verfahren zur Entscheidungsrückkopplungsentzerrung, umfassend:
Einspeisen eines Ausgangs eines Vorwärtsentzerrers (210) in einen ersten Eingang eines ersten Addierers (220);
Einspeisen eines Ausgangs des ersten Addierers (220) in einen zweiten Addierer (230);
Einspeisen eines Ausgangs des zweiten Addierers (230) in eine Entscheidungseinheit (240) und einen Ausgang, der den Entscheidungsrückkopplungsentzerrungsausgang des Verfahrens ausgibt;
Einspeisen eines Ausgangs der Entscheidungseinheit (240) in einen Eingangsanschluss eines Rückkopplungsentzerrers (250) und in einen Engangsanschluss eines N-Abgriffsfilters (260);
Einspeisen eines Ausgangs des Rückkopplungsentzerrers (250) in einen zweiten Eingangsanschluss des ersten Addierers (220) ; und
Einspeisen eines Ausgangs des N-Abgriffsfilters (260) in einen zweiten Eingang des zweiten Addierers (230).

5. Verfahren zur Entscheidungsrückkopplungsentzerrung nach Anspruch 4, wobei das N-Abgriffsfilter als schnell arbeitende Logikschaltung realisiert ist.

6. Verfahren zur Entscheidungsrückkopplungsentzerrung nach Anspruch 4 oder 5, wobei das Verfahren in einem digitalen Fernsehempfänger ausgeführt wird.

## Revendications

1. Egaliseur à rétroaction de décision (200) comprenant :
un égaliseur à action anticipée (210) ;
un premier sommateur (220) ;
un deuxième sommateur (230) ;
un dispositif de décision (240) ;
un égaliseur à rétroaction (250) ; et
un filtre à N prises (260);
où l'égaliseur à action anticipée (210) est connecté à une première entrée du premier sommateur (220) ;
le deuxième sommateur (230) est couplé à un port de sortie du premier sommateur (220) ;
un port de sortie du deuxième sommateur (230) est connecté au dispositif de décision (240) et à la sortie de l'égaliseur à rétroaction de décision (200) ;
une sortie du dispositif de décision (240) est connectée à un port d'entrée de l'égaliseur à rétroaction (250) et à un port d'entrée du filtre à N prises (260) ;
une sortie de l'égaliseur à rétroaction (250) est couplée à un deuxième port d'entrée du premier sommateur (220) ; et
une sortie du filtre à N prises (260) est couplée à une deuxième entrée du deuxième sommateur (230).

2. Egaliseur à rétroaction de décision (200) selon la revendication 1, où le filtre à N prises (260) est réalisé en logique rapide.

3. Egaliseur à rétroaction de décision selon la revendication 1 ou 2, où l'égaliseur à rétroaction de décision (200) est apte à être utilisé dans un récepteur de télévision numérique.

4. Procédé d'égalisation à rétroaction de décision, comprenant :
l'application d'une sortie d'un égaliseur à action anticipée (210) à une première entrée d'un premier sommateur (220) ;
l'application d'une sortie du premier sommateur (220) à un deuxième sommateur (230) ;
l'application d'une sortie du deuxième sommateur (230) à un dispositif de décision (240) et à une sortie sortant la sortie d'égalisation à rétroaction de décision du procédé ;
l'application d'une sortie du dispositif de décision (240) à un port d'entrée d'un égaliseur à rétroaction (250) et à un port d'entrée d'un filtre à N prises (260) ;
l'application d'une sortie de l'égaliseur à rétroaction (250) à un deuxième port d'entrée du premier sommateur (220) ; et
l'application d'une sortie du filtre à N prises (260) à une deuxième entrée du deuxième sommateur (230).

5. Procédé d'égalisation à rétroaction de décision selon la revendication 4, où le filtre à N prises est réalisé en logique rapide.

6. Procédé d'égalisation à rétroaction de décision selon la revendication 4 ou 5, où le procédé est exécuté dans un récepteur de télévision numérique.
